# EUROPEAN PATENT SPECIFICATION

(11) **EP 3 940 806 B1**
(45) Date of publication and mention of the grant of the patent: **16.08.2023**
(21) Application number: 20185783.6
(22) Date of filing: 14.07.2020
(51) Int. Cl.: H10K 30/15, H10K 71/30

(54) **METHOD OF MODIFYING THE STRUCTURE OF PEROVSKITE FILMS**
VERFAHREN ZUR MODIFIZIERUNG DER STRUKTUR VON PEROWSKITFILMEN
PROCÉDÉ DE MODIFICATION DE LA STRUCTURE DE FILMS DE PÉROVSKITE

(43) Date of publication of application: 19.01.2022
(73) Proprietor: ECOLE POLYTECHNIQUE FEDERALE DE LAUSANNE (EPFL), 1015 Lausanne (CH)
(72) Inventor: Zhang, Hong, 1020 Renens (CH); Zakeeruddin, Shaik Mohammed, 1030 Bussigny (CH); Graetzel, Michael, 1025 St-Sulpice (CH)
(74) Representative: Ganguillet, Cyril

(56) References cited:
- WO-A1-2019/077358
- MICHAEL SALIBA ET AL: "Cesium-containing triple cation perovskite solar cells: improved stability, reproducibility and high efficiency", ENERGY & ENVIRONMENTAL SCIENCE, vol. 9, no. 6, 16 March 2016 (2016-03-16), pages 1989-1997, XP055457076, Cambridge ISSN: 1754-5692, DOI: 10.1039/C5EE03874J
- TZU-SEN SU ET AL: "Crown Ether Modulation Enables over 23% Efficient Formamidinium-Based Perovskite Solar Cells", JOURNAL OF THE AMERICAN CHEMICAL SOCIETY, vol. 142, no. 47, 10 November 2020 (2020-11-10), pages 19980-19991, XP055755705, US ISSN: 0002-7863, DOI: 10.1021/jacs.0c08592

## Description

The project leading to this application has received funding from the European Union's Horizon 2020 research and innovation programme under grant agreements No 785219, 881603 and 764047.

### Field of the invention

The field of the invention relates to perovskite layers in perovskite based optoelectronic devices, in particular in perovskite based solar cells (PSCs).

More specifically, the present invention pertains to a method of modifying the structure of a perovskite film prepared on a substrate, said substrate intended as a part of such a perovskite based optoelectronic device.

The present invention pertains also to an optoelectronic device, in particular a perovskite solar cell, comprising a perovskite layer modified as mentioned above.

### Background of the invention and state of the art

Perovskite optoelectronic devices e.g., perovskite solar cells, perovskite light-emitting diodes, and perovskite photodetectors, have drawn enormous attention with remarkably high performance and prospective for low-cost fabrication. In particular, hybrid metal halide perovskite materials have been successfully used as light absorbing layer in solar cells due to their facile preparation process as well as their excellent optoelectronic properties^{[1]}. The power conversion efficiency (PCE) of perovskite solar cells reached about 23-25% during the past few years. A new certificated efficiency of 25.2% has recently been achieved in perovskite solar cells, which enables them as a very promising candidate to be used for next-generation photovoltaics.

However, perovskite optoelectronic devices still suffer from poor stability caused by defects on the surface of and in the bulk perovskite film. These defects are formed in particular by the volatilization of some organic compounds, e.g. methylamine, formamidinium and methylammonium, during the thermal annealing process step of perovskite formation. Conventional surface passivation is a partial solution to remove such defects from the surface of perovskite films.^{[8]} However, a number of defects remain in the bulk and it would be beneficial to develop a method that can simultaneously address both surface and bulk defects.

Formamidinium lead iodide (FAPbI₃) is considered to be one of the best perovskite materials for photovoltaic applications due to its narrow bandgap.^{[5]} However, the photoactive black α phase readily transforms to the undesired wide-bandgap δ phase under ambient conditions at room temperature. To address the thermodynamic instability of α- FAPbI₃, it has been shown that incorporation of Cs ions in the precursor solution helps to stabilize the black α phase. However, this comes at the expense of the optimal bandgap and it is accompanied by detrimental defects in the bulk as well as on the surface of perovskite films, which limits further improvement of performance.

Also, doping by means of additives has been employed in the art to tune the optical and electrical properties of perovskite materials. This has been described by M. Saliba et al^{[8]} and in WO 2019/077358. The inventors have found that a small amount of cesium iodide (CsI) incorporated into a perovskite precursor solution could increase the fill factor; however, the open-current voltage (*V*_{OC}) cannot be improved a lot by this strategy.

### Objectives of the invention

It is the object of the present invention to overcome the above-mentioned difficulties and to realize perovskite layers and films free from such defects.

### Solution according to the invention

To this effect, the present invention proposes a method of modifying the structure of a perovskite film prepared on a substrate, wherein an organic or inorganic salt crown ether complex is applied on a free surface of the so-prepared perovskite film.

The invention proposes thus a method to passivate the above-mentioned defects, in a post-deposition treatment on the as-formed perovskite films, by an organic or inorganic salt comprising an organic or inorganic cationic entity and an organic or inorganic anionic entity.

Preferably, an inorganic cationic entity is selected from the group consisting of the following cations: Tl⁺, Ag⁺, Li⁺, Na⁺, K⁺, Rb⁺, Cs⁺, Mg²⁺, Ca²⁺, Sr²⁺, Ba²⁺, Zn²⁺, Cu²⁺, Ni²⁺, Co²⁺, Cd²⁺, Ge²⁺, Sn²⁺, Pb²⁺, Hg²⁺, Al³⁺, Ga³⁺, In³⁺, Bi³⁺, Al³⁺, La³⁺, Ce³⁺, Eu³⁺, Th⁴⁺.

Preferably, an organic cationic entity of the component salt is selected from the group consisting of: 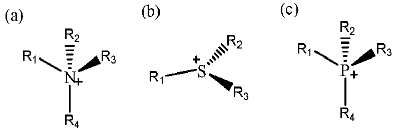 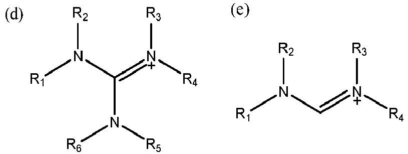 wherein
any R₁, R₂, R₃, R₄, R₅, R₆ is, independently one from the others:
- H, provided that at least one of R₁, R₂, R₃, R₄, R₅, R₆ connected to a heteroatom is not H; or
- a straight alkyl or branched alkyl containing 1-20 carbon atoms; or,
- straight alkenyl or branched alkenyl containing 2-20 carbon atoms and one or more double bonds; or
- a straight alkynyl or branched alkynyl containing 2-20 carbon atoms and one or more triple bonds; or
- a saturated, partial saturated or completely unsaturated cyclic alkyl containing 3-7 carbon atoms.

Preferred substituents R₁, R₂, R₃, R₄, R₅, R₆ of the organic cations may be independently selected from -H, -CH₃, -C₂H₅, -C₃H₇, -CH(CH₃)₂, -C₄H₉, -C(CH₃)₃, -C₅H₁₁, -C₆H₁₃,-C₇H₁₅, -C₈H₁₇, -C₉H₁₉, -C₁₀H₂₁, -C₁₂H₂₅, -C₂₀H₄₁, -OCH₃, -OCH(CH₃)₂, -CH₂OCH₃,-C₂H₄OCH(CH₃)₂, -SCH₃, -SCH(CH₃)₂, -C₂H₄SC₂H₅, -C₂H₄SCH(CH₃)₂, -S(O)CH₃,-SO₂CH₃, -SO₂C₂H₅, -SO₂C₃H₇, -SO₂CH(CH₃)₂, -CH₂SO₂CH₃, -OSO₂CH₃, -OSO₂CF₃,-CH₂NHC₂H₅, -N(CH₃)C₃H₅, -N(CH₃)CF₃, -O-C₄H₈-O-C₄H₉, -S-C₂H₄-N(C₄H₉)₂, -OCF₃,-S(O)CF₃, -SO₂CF₃, -CF₃, -C₂F₅, -C₃F₇, -C₄F₉, -C(CF₃)₃, -CF₂SO₂CF₃, -C₂F₄N(C₂F₅)C₂F₅,-CF=CF₂, -C(CF₃)=CFCF₃, -CF₂CF=CFCF₃, -CF=CFN(CF₃)CF₃, -CFH₂, -CHF₂, -CH₂CF₃, -C₂F₂H₃, -C₃FH₆, -CH₂C₃F₇, -C(CFH₂)₃, -CHO, -C(O)OH, -CHC(O)OH, -CH₂C(O)C₂H₅,-CH₂C(O)OCH₃, -CH₂C(O)OC₂H₅, -C(O)CH₃, -C(O)OCH₃,

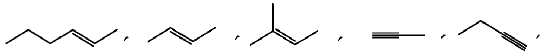

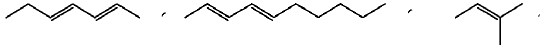

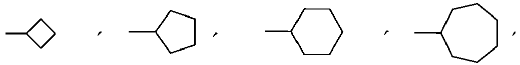

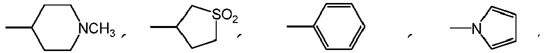

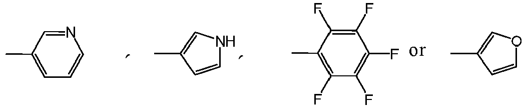

Preferably the anionic entity is selected from the group consisting of: F⁻, I⁻, Br⁻, Cl⁻, [N(CN)₂]⁻, [N(SO₂CF₃)₂]⁻, [PF₆]⁻, [BF₄]⁻, [NO₃]; [C(CN)₃]⁻, [B(CN)₄]⁻, [CF₃COO]⁻, [ClO₄]⁻, [RSO₃]⁻, [(RSO₂)₂N]⁻, [(RSO₂)₃C]⁻, [(FSO₂)₃C]⁻, [RCH₂OSO₃]⁻, [RC(O)O]⁻, [CCl₃ C(O)O]⁻, [(CN)₂CR]⁻, [(R¹O(O)C)₂CR]⁻, [P(CₙF₂ₙ₊₁₋ₘHₘ)_{y}F_{6-y}]⁻, [P(C₆H₅)_{y}F_{6-y}]⁻, [R¹₂P(O)O]⁻, [R¹P(O)O₂]²⁻, [(R¹O)₂P(O)O]⁻, [(R¹O)P(O)O₂]²; [(R¹O)(R¹)P(O)O]⁻, [R₂P(O)O]⁻, [RP(O)O₂]⁻, [BF₂R_{4-Z}]⁻, [BF₂(CN)_{4-z}]⁻, [B(C₆F₅)₄]⁻, [B(OR¹)₄]⁻, [N(CF₃)₂]⁻, [AlCl₄]⁻ or [SiF₆]²⁻;
wherein:
- n is an integer 1-20; m is 0, 1, 2, or 3; y is 0, 1, 2, 3 or 4; z is 0, 1, 2, or 3;

R and R¹ are independently selected from:
   - completely fluorinated alkyl containing 1-20 carbon atoms;
   - completely fluorinated alkenyl containing 2-20 carbon atoms and one or more double bonds; or,
   - completely fluorinated phenyl; or,
      saturated, partially unsaturated and/ or completely unsaturated cycloalkyl, or
saturated, partially unsaturated and/ or completely unsaturated perfluoroalkyl.

The terminology « post-deposition treatment» is used herein to designate a treatment effected after completion of a deposition process of a perovskite film on a substrate, said deposition process including both application of perovskite components on a substrate and annealing of the film. This post-deposition treatment is realized by treating the as-prepared perovskite films with an organic or inorganic salt crown ether complex in an appropriate solution. The organic or inorganic salt can separate thereafter from the complex and diffuse into the bulk film through thermal annealing, to form a vertically graded concentration of organic or inorganic salt incorporated in the perovskite film. The invention thus offers a method that addresses both surface and bulk defects through a post-deposition treatment that achieves simultaneous modulation of the surface and bulk composition in perovskite films by forming a gradient organic or inorganic salt concentration within said structure.

In particular, whereas a perovskite film is formed by depositing perovskite precursors in a first solution in a first solvent onto said substrate and thereafter submitting the substrate covered by a film of said first solution to a first annealing step, said organic or inorganic salt crown ether complex is applied in a second solution in a second solvent, wherein said second solvent is orthogonal to said first solvent versus said perovskite. After the application step of said organic or inorganic salt crown ether complex, said substrate with said perovskite film and with said applied organic or inorganic salt crown ether complex is preferably submitted to a second annealing step.

In another aspect, the invention offers an optoelectronic device, in particular a perovskite solar cell, wherein a perovskite layer contains an organic or inorganic salt presenting a graded concentration within said perovskite layer, the highest concentration of said organic or inorganic salt existing in vicinity of the perovskite layer surface distal to the substrate of said perovskite layer.

Other features and advantages of the present invention are mentioned in the dependent claims as well as in the following detailed description disclosing, with reference to the figures, preferred embodiments of the invention in more detail.

### Short description of the figures

The attached figures exemplarily and schematically illustrate the principles as well as several embodiments of the present invention.
Figure 1: is a scheme of an (AX)-crown ether complex treatment.
Figure 2: 1H NMR spectra of dibenzo-21-crown-[7] dissolved in dichloromethane-d² (top), and CsI-crown ether complex dissolved in dichloromethane-d² (bottom).
Figure 3: XPS spectra for Cs 3d (a) and O 1s (b) core-level spectra. (c) XPS depth profiles of Cs 3d spectra.
Figure 4: Top-view, SEM images of perovskite without (a) and with (b) CsI crown ether complex post-deposition treatment.
Figure 5: (a) *V*_{OC}, FF, *J*_{SC} and PCE matrix of PSCs with and without CsI-post-deposition treatment.
   (b) J-V curves of PSCs with and without CsI- post-deposition treatment. The inset shows the maxium power point tracking data.
   (c) J-V curves and (d) IPCE spectra of FAPbI₃ PSCs with and without CsI- post-deposition treatment.
Figure 6: *J-V* curves of typical PSCs with and without CsX- post-deposition treatment (X=F, Cl, Br).
Figure 7: Ambient stability of control perovskite film;
   (a) and (b) target perovskite film. XRD patterns of the perovskite films stored in an ambient environment for various times. The humidity and temperature are 60 ± 10% and 25 ± 1 °C, respectively.
   (c) Maximum power point tracking measured with the unencapsulated target device under full solar illumination (AM 1.5 G, 100 mW/cm² in N2, 25°C).

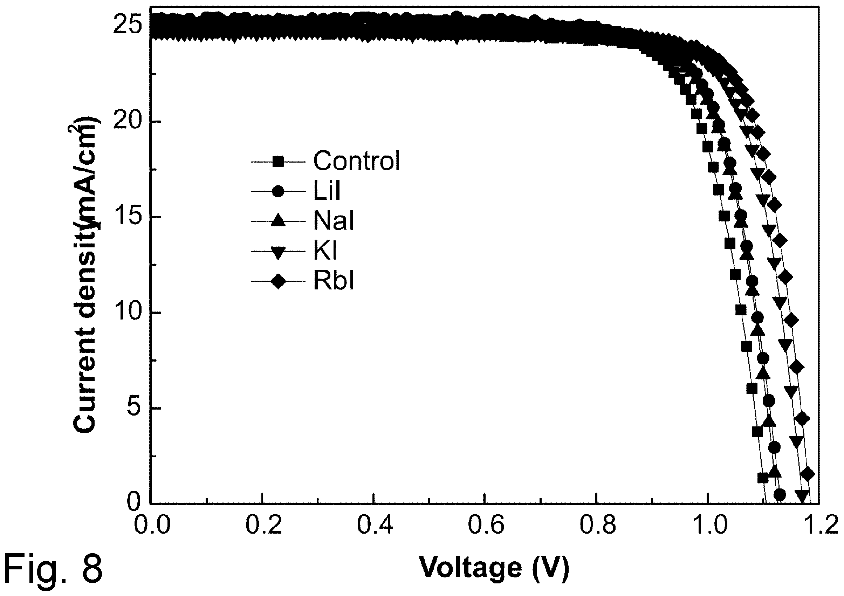

Figure 8: *J-V* curves of typical PSCs with and without AI post-deposition treatment (A=Li, Na, K, Rb).

### Detailed description of the invention

In the following, embodiments of the invention shall be described in detail with reference to the above-mentioned figures.

In one aspect, the invention is a processing method to passivate defects of perovskite layers by means of an organic or inorganic salt treatment on the as-formed perovskite films.

Inorganic cations embodying the invention are: Tl⁺, Ag⁺, Li⁺, Na⁺, K⁺, Rb⁺, Cs⁺, Mg²⁺, Ca²⁺, Sr⁺, Ba²⁺, Zn²⁺, Cu²⁺, Ni²⁺, Co²⁺, Cd²⁺, Ge²⁺, Sn²⁺, Pb²⁺, Hg²⁺, Al³⁺, Ga³⁺, In³⁺, Bi³⁺, Al³⁺, La³⁺, Ce³⁺, Eu³⁺, Th⁴⁺ may be used.

2) Organic cations of the component salts embodying the invention are: 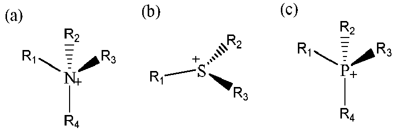 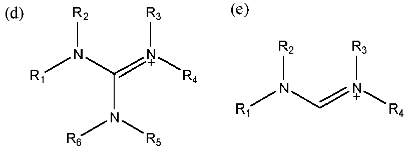 wherein
any R₁, R₂, R₃, R₄, R₅, R₆ is independently selected from:
- H, provided that at least one R connected to a heteroatom is not H;
- a straight alkyl or branched alkyl containing 1-20 carbon atoms; or,
- straight alkenyl or branched alkenyl containing 2-20 carbon atoms and one or more double bonds;
- a straight alkynyl or branched alkynyl containing 2-20 carbon atoms and one or more triple bonds;
- a saturated, partial saturated or completely unsaturated cyclic alkyl containing 3-7 carbon atom.

Preferred substituents R₁, R₂, R₃, R₄, R₅, R₆ of the organic cations are -H, -CH₃, -C₂H₅,-C₃H₇, -CH(CH₃)₂, -C₄H₉, -C(CH₃)₃, -C₅H₁₁, -C₆H₁₃, -C₇H₁₅, -C₈H₁₇, -C₉H₁₉, -C₁₀H₂₁,-C₁₂H₂₅, -C₂₀H₄₁, -OCH₃, -OCH(CH₃)₂, -CH₂OCH₃, -C₂H₄OCH(CH₃)₂, -SCH₃,-SCH(CH₃)₂, -C₂H₄SC₂H₅, -C₂H₄SCH(CH₃)₂, -S(O)CH₃, -SO₂CH₃, -SO₂C₂H₅, -SO₂C₃H₇,-SO₂CH(CH₃)₂, -CH₂SO₂CH₃, -OSO₂CH₃, -OSO₂CF₃, -CH₂NHC₂H₅, -N(CH₃)C₃H₅,-N(CH₃)CF₃, -O-C₄H₈-O-C₄H₉, -S-C₂H₄-N(C₄H₉)₂, -OCF₃, -S(O)CF₃, -SO₂CF₃, -CF₃,-C₂F₅, -C₃F₇, -C₄F₉, -C(CF₃)₃, -CF₂SO₂CF₃, -C₂F₄N(C₂F₅)C₂F₅, -CF=CF₂, -C(CF₃)=CFCF₃, -CF₂CF=CFCF₃, -CF=CFN(CF₃)CF₃, -CFH₂, -CHF₂, -CH₂CF₃, -C₂F₂H₃, -C₃FH₆,-CH₂C₃F₇, -C(CFH₂)₃, -CHO, -C(O)OH, -CHC(O)OH, -CH₂C(O)C₂H₅, -CH₂C(O)OCH₃,-CH₂C(O)OC₂H₅, -C(O)CH₃, -C(O)OCH₃,

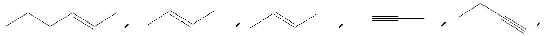

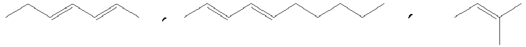

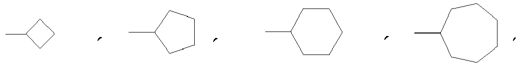

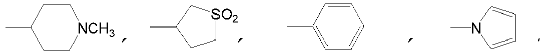

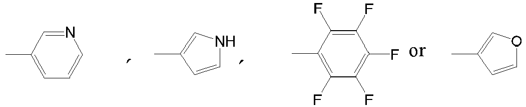

3) Anions embodying the invention are F⁻, I⁻, Br⁻, Cl⁻, [N(CN)₂]⁻, [N(SO₂CF₃)₂]⁻, [PF₆]⁻, [BF₄]⁻, [NO₃]⁻, [C(CN)₃]⁻, [B(CN)₄]⁻, [CF₃COO]⁻, [ClO₄]⁻, [RSO₃]⁻, [(RSO₂)₂N]⁻, [(RSO₂)₃C]⁻, [(FSO₂)₃C]⁻, [RCH₂OSO₃]⁻, [RC(O)O]⁻, [CCl₃ C(O)O]⁻, [(CN)₂CR]⁻, [(R¹O(O)C)₂CR]⁻, [P(CₙF₂ₙ₊₁₋ₘHₘ)_{y}F_{6-y}]⁻, [P(C₆H₅)_{y}F_{6-y}]⁻, [R¹₂P(O)O]⁻, [R¹P(O)O₂]²⁻, [(R¹O)₂P(O)O]⁻, [(R¹O)P(O)O₂]²⁻, [(R¹O)(R¹)P(O)O]⁻, [R₂P(O)O]⁻, [RP(O)O₂]⁻, [BF₂R_{4-Z}]⁻, [BF_{Z}(CN)_{4-Z}]⁻, [B(C₆F₅)₄]⁻, [B(OR¹)₄]⁻, [N(CF₃)₂]⁻, [AlCl₄]⁻ or [SiF₆]²⁻;
wherein:
- n is an integer 1-20; m is 0, 1, 2, or 3; y is 0, 1, 2, 3 or 4; z is 0, 1, 2, or 3;
Rand R¹ are independently selected from:
- completely fluorinated alkyl containing 1-20 carbon atoms;
- completely fluorinated alkenyl containing 2-20 carbon atoms and one or more double bonds; or,
- completely fluorinated phenyl; or, saturated, partially unsaturated and or completely unsaturated cycloalkyl; said cycloalkyl can be replaced by perfluoroalkyl.

This processing method is realized by treating the as-formed perovskite films with an organic or inorganic salt-crown ether complex in a solution. Thereafter the organic or inorganic salt is able to separate from the complex and diffuse into the bulk perovskite film through thermal annealing, to form a vertically graded organic or inorganic salt-incorporated perovskite film.

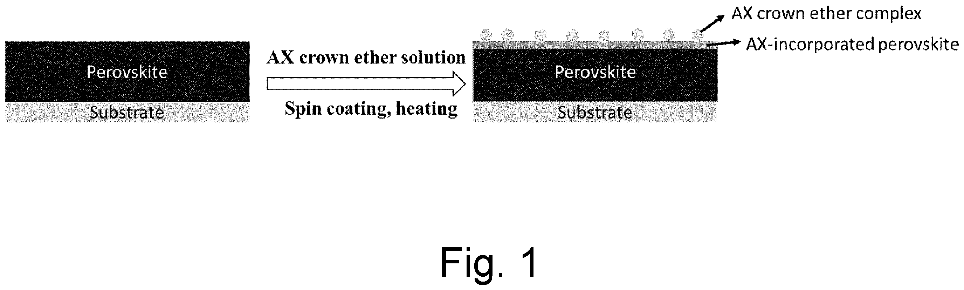

In a particular embodiment, the invention proposes a method to passivate above mentioned defects , by means of a post-deposition treatment on the as-formed perovskite films, by an alkali metal halide AX, wherein A=Li, Na, K, Rb, or Cs and X= F, Cl, Br or I. Figure 1 illustrates this process.

Preparations of perovskite films on substrates forming parts of optoelectronic devices are nowadays largely known in the art, so that a general description thereof is not necessary here. For exemplary purposes, a cursorily description of the preparation of a organic-inorganic hybrid or inorganic perovskite film (B C¹ Y₃) film on a substrate suitable as part of a PSC is given hereunder, where B is CH₃NH₃⁺, CH₃CH₂NH₃⁺, HC(NH₂)₂⁺, C(NH₂)₃⁺, C₆H₅CH₂CH₂NH₃⁺, CH₃(CH₂)₃NH₃⁺, (CH₃)₂CHCH₂NH₃⁺, Cs⁺, or a mixture of them; C¹ is Pb, Sn, Bi, or an alloy thereof; Y is I, Cl, Br, SCN, or a mixture thereof, though embodiments are not limited thereto. The implementation of the present invention does not preclude the simultaneous use of additives in precursor solutions of perovskite films for conventional surface passivation to remove bulk defects.

The polar solvents that are commonly used for dissolving organic or inorganic salts (e.g., water, dimethylformamide, dimethyl sulfoxide, etc.) could dissolve or damage the perovskite film. Therefore, these polar solvents cannot be employed to dissolve such salts for the post-deposition treatment.

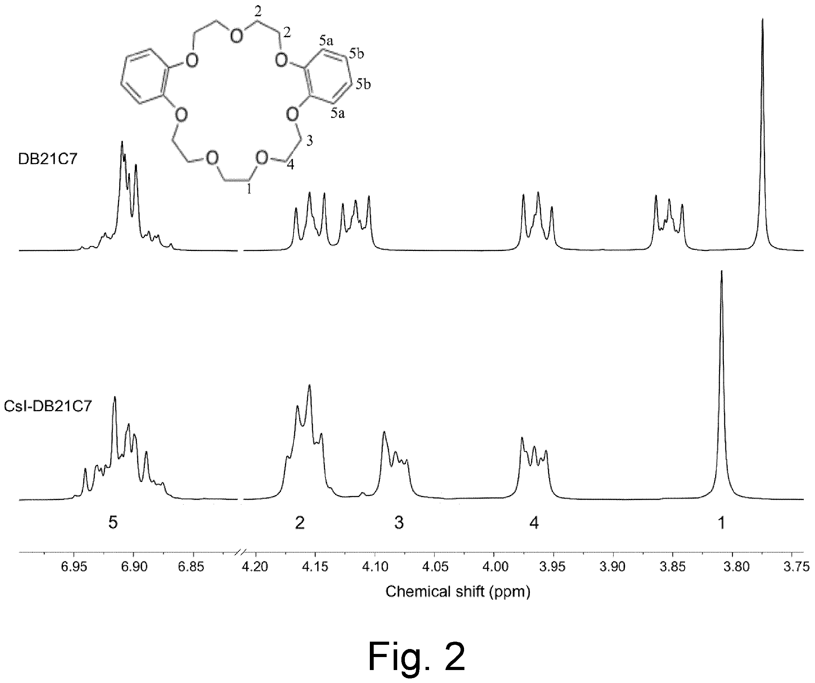

Crown ethers are known to serve as shuttles in a host-guest relationship for different organic and metal cations, such as in phase-transfer catalysis, forming host-guest complexes via ion-dipole interactions between the oxygen atoms of the macrocycle and the metal or organic cation, with remarkable selectivity for certain alkali metal ions as determined by the size of the macrocycle.^{[9,10]} This property is used in the framework of the present invention to transfer organic or inorganic salts, in particular AX salts, onto the perovskite film by dissolving the host-guest complex in an orthogonal non-polar solvent. For example, dibenzo-21-crown-7 (DB21C7) presents a good size complementarity of its cavity (3.4-4.3 Å) with Cs⁺ cations (3.3 Å), forming a well-defined host-guest complex (Fig. 2). The dibenzo-21-crown-[7] is rationally chosen because its cavity is of sufficient size (3.4-4.3 Å) to coordinate the Cs+ cations (3.3 Å) via weak van der Waals interactions with the lone electron pairs of the oxygen atoms within the ring structure, forming a CsI crown ether complex. Moreover, this complex is soluble in non-polar solvents, which is compatible with solution-processing of the perovskite film.

Organic or inorganic salt crown ether complexes are synthesized by mixing a crown ether and an organic or inorganic salt in an ultra-dry solvent and stirring, preferably at a selected warm temperature as disclosed hereunder, for several days. Upon finish, the solution is preferably filtered and directly used for device fabrication. The concentration of organic or inorganic salt crown ether complex in the solution is controlled by the amount of crown ether. The synthesis of a CsI-DB21C7 complex is detailed as an example hereunder.

The crown ether used in this method can be 12-crown-[4], 15-crown-[5], 18-crown-[6], benzo-18-crown-[6], dibenzo-18-crown-[6], [2,4]-dibenzo-18-crown-[6], dibenzo-21-crown-[7], dibenzo-24-crown-[8], dibenzo-30-crown-[10], dicyclohexyl-18-crown-[6], *N-*phenylaza-15-crown-[5], 4',4"(5")-di-*tert*-butyldicyclohexano-18-crown-[6], 1,4,8,12-tetraazacyclopentadecane, 1,4,8,11-tetrathiacyclotetradecane, hexacyclen, 1,5,9,13-Tetrathiacyclohexadecane, 1-aza-18-crown-[6], diaza-18-crown-[6], hexaza-18-crown-[6], hexathia-18-crown-[6] or a mixture thereof.

The solvent used for the synthesis of an organic or inorganic salt crown ether complex , which is preferably also to be used in the deposition step of the inventive method can be toluene, n-hexane, chloroform, iodobenzene, chlorobenzene, anisole, ethyl acetate, methyl acetate, sec-butanol, acetonitrile, or a mixture thereof.

The reaction duration time for the synthesis of organic or inorganic salt crown ether complex can be, for example, any of the following values, about any of the following values, at least any of the following values, no more than any of the following values, or within any range having any of the following values as endpoints (all values are in hours), though embodiments are not limited thereto: 1, 5, 10, 20, 25, 30, 35, 40, 45, 50, 55, 60, 65, 70, 75, 80, 85, 90, 95, 100, 105, 110, 115, 120, 125, 130, 135, 140, 145, 150, 155, 160, 165, 170, 175 or 180.

The reaction temperature for the synthesis of organic or inorganic salt crown ether complex can be, for example, any of the following values, about any of the following values, at least any of the following values, no more than any of the following values, or within any range having any of the following values as endpoints (all values are in Celsius degree), though embodiments are not limited thereto: 20, 25, 30, 35, 40, 45, 50, 55, 60, 65, 70, 75, 80, 85, 90, 95, 100, 105, 110, 115, 120, 125, 130, 135, 140, 145 or 150.

The process of organic or inorganic salt crown ether complex treatment is schematically represented in Fig. 1 and is described as follows. Firstly, the organic or inorganic salt crown ether complex solution is coated on the as-prepared perovskite film. Several application methods may be implemented in applying said organic or inorganic salt crown ether complex onto the so-prepared perovskite film and may be chosen by those skilled in the art in particular among spin-coating, spray-coating, immersion, etc... After that, thermal annealing treatment is employed to promote the diffusion of the salt into the bulk of perovskite film for several minutes. This treatment significantly modifies the composition (both surface and bulk) and surface morphology of perovskite films. As a consequence, the performance and stability of perovskite solar cells are improved simultaneously.

The thermal temperature of the organic or inorganic salt crown ether complex treated perovskite can be, for example, any of the following values, about any of the following values, at least any of the following values, no more than any of the following values, or within any range having any of the following values as endpoints (all values are in Celsius degree), though embodiments are not limited thereto: 20, 25, 30, 35, 40, 45, 50, 55, 60, 65, 70, 75, 80, 85, 90, 95, 100, 105, 110, 115, 120, 125, 130, 135, 140, 145, 150, 155, 160, 165, 170, 175, 180, 185, 190, 195, 200, 205, 210, 215, 220, 225, 230, 235, 240, 245, 250, 255, 260, 265, 270, 275, 280, 285, 290, 295 or 300.

The duration time of the organic or inorganic salt crown ether complex treatment can be, for example, any of the following values, about any of the following values, at least any of the following values, no more than any of the following values, or within any range having any of the following values as endpoints (all values are in minutes), though embodiments are not limited thereto: 1, 5, 10, 20, 25, 30, 35, 40, 45, 50, 55, 60, 65, 70, 75, 80, 85, 90, 95, 100, 105, 110, 115, 120, 125, 130, 135, 140, 145, 150, 155, 160, 165, 170, 175 or 180.

Thus, the whole post deposition treatment may be summarized as follows:

Crown-ether + AX → AX(crown-ether)complex (1)

*x* AX(crown ether) complex + BC¹Y₃ → AX.BC¹Y₃ + *x* crown ether (2)

After the organic or inorganic salt crown ether complex treatment, additional layer with 2D materials can be coated. The 2D materials can be graphite, graphene, doped graphene, graphene oxide, doped graphene oxide, molybdenum disulfide, hafnium disulfide, tungsten diselenide, MXenes, graphitic carbon nitride.

### Example 1: treatment of a perovskite film with CsI

### a) Preparation of a perovskite layer on a substrate.

An F-doped SnO₂ FTO conductive glass substrate is cleaned with solvents, dried with compressed air, and UV-Ozone treatment for 15 min is applied for further cleaning. Compact TiO₂ (c-TiO₂) is deposited on top of FTO using spray pyrolysis. After spray pyrolysis, the FTO/c-TiO₂ substrate is allowed to heat at 450 °C for 30 min before cooling down. Mesoscopic TiO₂ (mp-TiO₂) is applied by spin-coating of a diluted solution of TiO₂-30 NRD paste, then sintering at 450 °C for 60 minutes to obtain mp-TiO₂ substrate. A 0.1M LiTFSI solution is then coated on the mp-TiO₂ and another sintering process at 450 °C for 30 min is conducted. The Li-treated mp-TiO₂ substrate is transferred to a dry box for device fabrication intermediately.

For a (FAPbI₃)_{1-*x*}(MAPbBr₃)*ₓ* precursor solution preparation, a mixture of PbI₂, formamidinium iodide (FAI), methylammonium lead tribromide (MAPbBr₃₎ and methylammonium chloride (MACl) is dissolved in a mixed solution of DMF and DMSO (volume ration of DMF/DMSO of 4:1). For pure FAPbI₃ precursor solution preparation, a mixture of PbI₂, FAI and MACl is dissolved in a mixed solution of DMF and DMSO (volume ration of DMF/DMSO of 4:1). For a Cs homogeneously doped perovskite, a CsI solution in DMSO is added to the (FAPbI₃)_{1-*x*}(MAPbBr₃)*ₓ* precursor solution. The perovskite active layer is deposited using antisolvent method. The perovskite precursor solution is deposited on the freshly prepared FTO/c-TiO₂/mp-TiO₂ substrate with a two-step spin-coating method at 1000 rpm for 10s and followed by 5000 rpm for 25 s. An effective amount of diethyl ether is applied at the last 10s. After spin-coating, the substrate is allowed to anneal at 150 °C for 10 min, then 100 °C for 10 min. The whole procedure is done in dry air.

### b) Synthesis of CsI-DB21C7 complex.

CsI-DB21C7 complex is synthesized by mixing DB21C7 and CsI with 1:1.2 mole ratio in dry chlorobenzene and stirring at 50 °C for 7 days. The solution is filtered and used for device fabrication directly. The concentration of CsI-DB21C7 complex solution is controlled by the amount of crown ether. The complexation is subsequently verified by proton nuclear magnetic resonance (¹H NMR), where weak chemical shifts of approximately Δδ +0.01-0.05 ppm are observed upon coordination (Figure 2).

### c) Post-deposition treatment.

This CsI-DB21C7 complex is dissolved in chlorobenzene, which is « friendly » to perovskite, since it does not dissolve the latter. This CsI crown ether solution is used to treat the as- prepared perovskite film. The CsI-DB21C7 treatment is conducted by coating the as-prepared perovskite with a solution of CsI-DB21C7 complex solution with various concentrations. The solutions are kept on surface of the perovskite film for 2 s, and substantially spin-coated at 4000 rpm for 30 seconds. The treated perovskite films are allowed to anneal at 100 °C for 5 min. After, the treated perovskite films are washed with chlorobenzene for several times.

### d) Structural features of treated perovskite film.

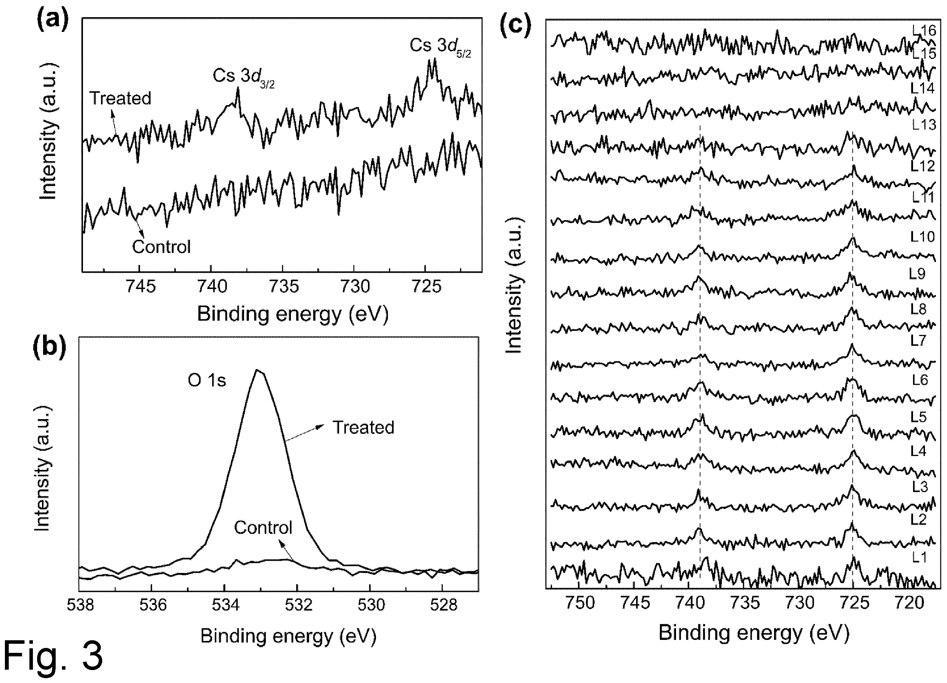

The surface and bulk composition of perovskite without and with cesium iodide induced post-deposition treatment were investigated by x-ray photoelectron spectroscopy (XPS). The Cs 3*d* spectra in Fig 3a shows obvious difference between control and target film. There is no Cs 3d signal in control film, while two peaks Cs 3*d*_{3/2} at 739.0 and Cs *3d*_{5/2} at 725.0 eV exist in target film, which verifies that CsI has been successfully transferred onto treated perovskite film via the help of crown ether. The new peak of O1*s* at 533.1 eV (CO) in Fig. 3b exists in the target film, indicates some crown ether species still left on the surface of treated perovskite film. To confirm whether Cs diffuses into the bulk or not, depth profiles of XPS were conducted. As shown in Fig. 3c, the Cs 3d signals could be detected after sputtering of approximately 450 nm (level 13) in the perovskite film (thickness of ~850 nm) after CsI-PDT. This result reveals that Cs gradually incorporates into the treated perovskite film from surface to bulk.

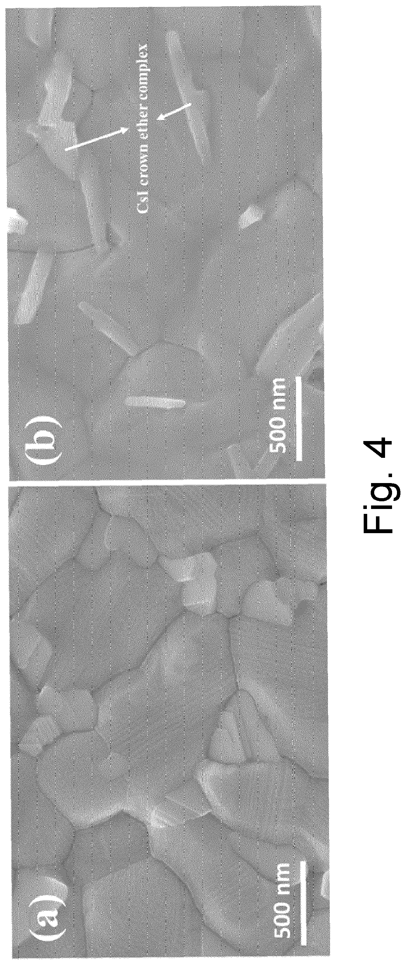

The morphology of perovskite film with and without CsI-PDT was studied by scanning electron microscope (SEM). As shown in the Fig. 4, the treated perovskite film shows larger grain size with some nanoneedles on the surface and few grain boundaries in the vertical direction.

### Example 2: Device performance of PSCs.

The device performance of PSCs with and with CsI-PDT were investigated.

A doped spiro-OMeTAD solution in chlorobenzene was spin-casted on the surface of the control and the treated perovskite films. Spiro-OMeTAD is doped by 23 µl LiTFSI (520 mg/mL in CH₃CN) and 39.5 µl 4-tert-butyl pyridine, and 10 µl FK209 (375 mg/mL in ACN). The whole procedure is carried out in dry air (temperature<28°; relative humidity <15%). The device fabrication is completed with deposition of gold electrode (~70 nm) by thermal evaporation.

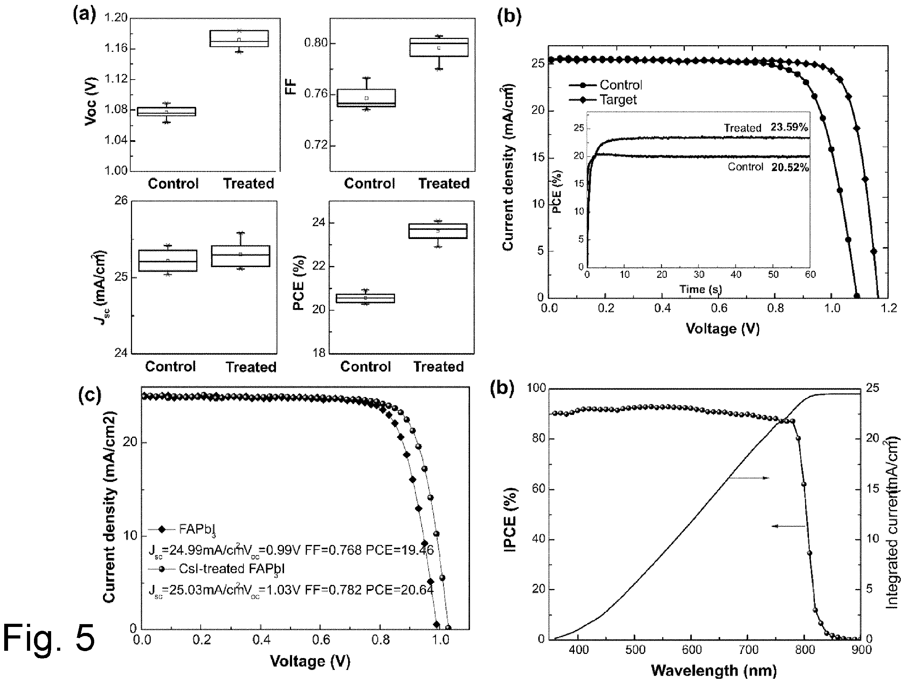

The PSCs present thus the following configuration: FTO/compact TiO₂ (~60 nm)/ mesoporous-TiO₂:perovskite composite layer (~150 nm)/perovskite upper layer (~650 nm)/ spiro-MeOTAD (~150 nm)/Au (~70 nm), and spiro- MeOTAD is 2,2',7,7'-Tetrakis[*N,N*-di(4-methoxyphenyl)amino]-9,9'-spirobifluorene. As shown in Fig. 5a, the CsI-post-deposition treatment significantly improves the performance of PSCs compared to that of control. Especially the open-current voltage (*V*_{OC}) improved from 1.08±0.01V to 1.17±0.01V and fill factor (FF) improved from 75.7±0.9% to 79.7±0.9%, which resulting in a significantly improvement of PCE (average) from 20.56±0.21% to 23.62±0.43%. Fig. 5b shows the current density-voltage (J-V) curves of the inventive target and control devices. The target PSC exhibited an open-current voltage (*V*_{OC}) of 1.17 V, a short-circuit current (*J*_{SC}) of 25.42 mA·cm⁻², and a fill factor (FF) of 81.7%, for a PCE of 24.29%. The control device showed an overall PCE of 21.08% with a *V*_{OC} of 1.09 V, a *J*_{SC} of 25.43 mA·cm⁻², and a FF of 76.0%. These values are further ascertained by recording scan speed-independent maximum power point tracking (MPP) measurement (Fig. 5b insert) corresponding to PCEs of 20.5% and 23.9% for the control and target PSCs, respectively.

Meanwhile, the CsI-Post Deposition Treatment can also be employed to fabricate highly efficient Br/MA- free FAPbI₃ PSCs. As shown in Fig. 5c, the *V*_{OC} and FF of FAPbI₃ PSCs were improved from 0.99V to 1.03V and 0.768 to 0.782, respectively. As a result, the PCE was improved from 19.46% to 20.64% (stabilized efficiency of 20.9%). The *J*_{SC} value obtained from the *J-V* characteristics is well matched (within 5%) with the IPCE (Fig. 5d).

### Example 3: Ambient stability of post-deposition treated/not treated perovskite films.

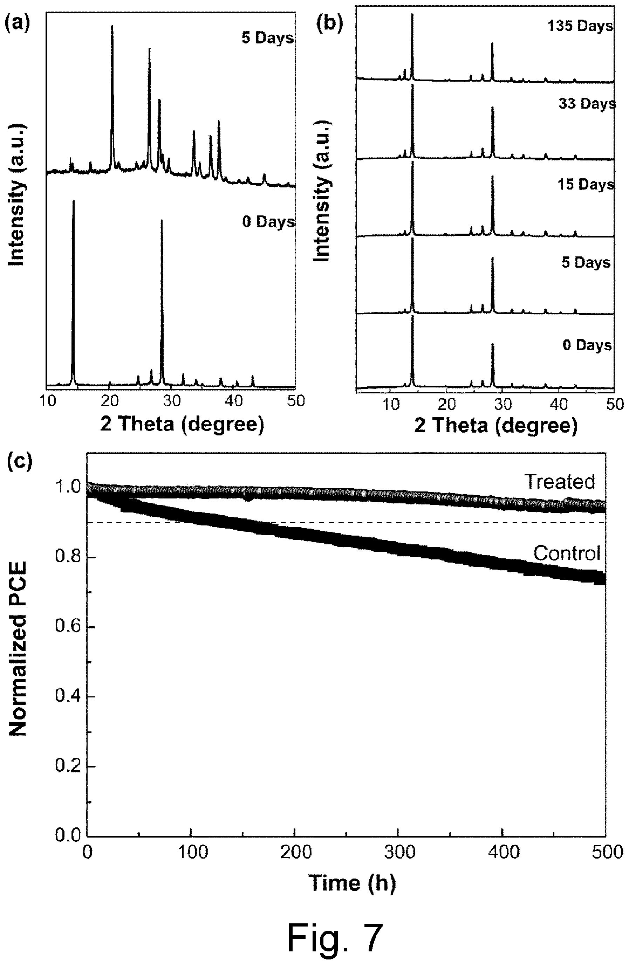

The stability of perovskite films and relevant device without and with CsI- post-deposition treatment is compared. Firstly, the air stability of perovskite film by exposing to ambient environment is studied. The humidity and temperature are 60 ± 10% and 25 ± 1 °C, respectively. As shown in **Fig. 7a**, CsI post-deposition treatment significantly enhances the air stability of perovskite film. The treated perovskite film was stable in air more than 135 days, while the control film was completely degraded within 5 days (Fig. 7b). The enhanced air stability of perovskite film could arise from two aspects: (i) reduction of vacancy by CsI and (ii) moisture diffusion barrier formed by CsI crown ether complex. In addition, the long-term operational stability of the PSCs under one-sun illumination by maximum power point tracking was tested (**Fig. 7b**). The target device exhibits very high photostability, maintaining >95% of its initial PCE over 500 hours of irradiation. While the control device degraded to 60% of initial PCE in the first 100 hours. This operational stability enhancement can be attributed to both the reduction of defects in the interface of hole transport material/perovskite and the stabilization of the α-phase on FAPbI₃ by CsI-post-deposition treatment.

### Example 4. Other metal halides.

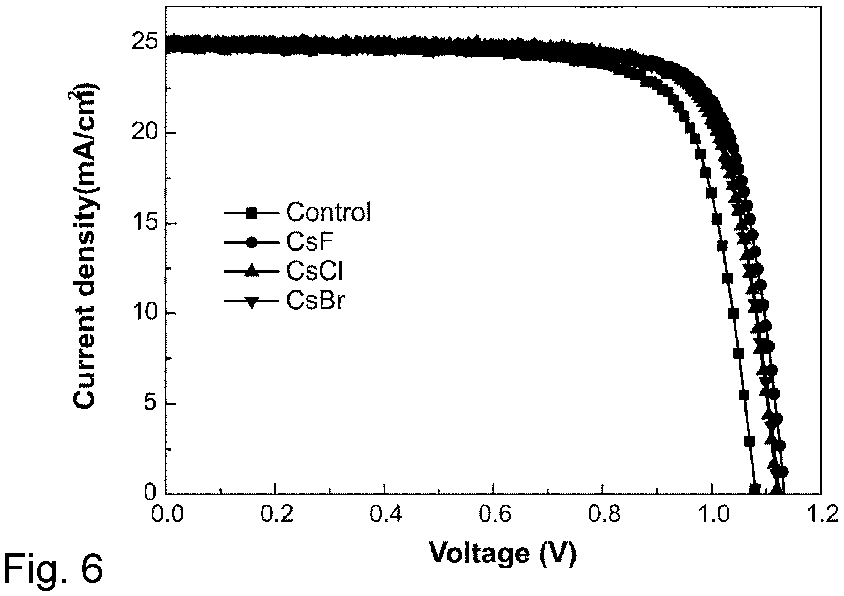

Cesium salts with different halides (F, Cl, and Br) can also be employed by this method. Figure 6 shows the typical J-V curves for the PSCs without and with different CsX-PDT (x=F, Cl, Br). It is clear that cesium salt with other halides also can improve the PSCs performance.

**. Table 1. The photovoltaic parameters obtained from the J-V curves in Figure 6.**

| | V_{OC} (V) | J_{SC} (mA/cm²) | FF | PCE (%) |
|---|---|---|---|---|
| Control | 1.081 | 24.7 | 0.764 | 20.39 |
| CsF-PDT | 1.134 | 24.75 | 0.787 | 22.07 |
| CsCl-PDT | 1.121 | 24.99 | 0.775 | 21.69 |
| CsBr-PDT | 1.124 | 24.8 | 0.779 | 21.69 |

Other alkali metal halides (AX, A=Li, Na, K, Rb) can be also transferred onto perovskite film with the assistance of a crown ether. Considering the different size of alkali metal cations, one may choose 15-crown-5 for LiX and NaX salts, dibenzo-18-crown-6 or benzo-18-crown-6 or 18-crown-6 and for KX salts, dibenzo-21-crown-7 for RbX salts. The synthesis and treatment are the same as for CsI. Figure 8 shows that different AI- post-deposition treatment (A=Li, Na, K, Rb) can also significantly improve the performance of PSCs, especially the *V*_{OC}.

**Table 2. The photovoltaic parameters obtained from the J-V curves in Figure 8.**

| | V_{OC} (V) | J_{SC} (mA/cm²) | FF | PCE (%) |
|---|---|---|---|---|
| Control | 1.105 | 24.87 | 0.778 | 21.38 |
| LiI-PDT | 1.132 | 25.28 | 0.779 | 22.66 |
| NaI-PDT | 1.126 | 24.77 | 0.786 | 21.90 |
| KI-PDT | 1.171 | 24.79 | 0.796 | 23.10 |
| RbI-PDT | 1.185 | 24.85 | 0.802 | 23.61 |

### REFERENCES

1 Correa-Baena, J.-P. et al. Homogenized halides and alkali cation segregation in alloyed organic-inorganic perovskites. Science 363, 627-631, doi:10.1126/science.aah5065 (2019).
2 Turren-Cruz, S.-H., Hagfeldt, A. & Saliba, M. Methylammonium-free, high-performance, and stable perovskite solar cells on a planar architecture. Science 362, 449-453 (2018).
3 Jeon, N. J. et al. Compositional engineering of perovskite materials for high-performance solar cells. Nature 517, 476-480, doi:10.1038/nature14133 (2015).
4 Ogomi, Y. et al. CH3NH3SnxPb(1-x)I3 Perovskite Solar Cells Covering up to 1060 nm. The Journal of Physical Chemistry Letters 5, 1004-1011, doi:10.1021/jz5002117 (2014).
5 Lin, R. et al. Monolithic all-perovskite tandem solar cells with 24.8% efficiency exploiting comproportionation to suppress Sn(ii) oxidation in precursor ink. Nature Energy 4, 864-873, doi:10.1038/s41560-019-0466-3 (2019).
6 Zhao, Y. & Zhu, K. Organic-inorganic hybrid lead halide perovskites for optoelectronic and electronic applications. Chemical Society Reviews 45, 655-689, doi:10.1039/C4CS00458B (2016).
7 Chen, H. et al. A solvent- and vacuum-free route to large-area perovskite films for efficient solar modules. Nature 550, 92-95, doi:10.1038/nature23877 (2017).
8 Saliba, M. et al. Cesium-containing triple cation perovskite solar cells: improved stability, reproducibility and high efficiency. Energy & Environmental Science 9, 1989-1997, doi:10.1039/C5EE03874J (2016).
9 Landini, D., Maia, A., Montanari, F. & Pirisi, F. M. Crown ethers as phase-transfer catalysts. A comparison of anionic activation in aqueous-organic two-phase systems and in low polarity anhydrous solutions by perhydrodibenzo-18-crown-6, lipophilic quaternary salts, and cryptands. J. Chem. Soc., Perkin Trans. 2, 46-51 (1980).
10 Steed, J. W. First-and second-sphere coordination chemistry of alkali metal crown ether complexes. Coord. Chem. Rev. 215, 171-221 (2001).

## Claims

1. A method of modifying the structure of a perovskite film prepared on a substrate, **characterised by the fact that** an organic or inorganic salt crown ether complex is provided and that said organic or inorganic salt crown ether complex is applied on a free surface of the so-prepared perovskite film.

2. Method according to claim 1, **characterised by** the fact that said organic or inorganic salt comprises an inorganic cation selected from the group consisting of: Tl⁺, Ag⁺, Li⁺, Na⁺, K⁺, Rb⁺, Cs⁺, Mg²⁺, Ca²⁺, Sr²⁺, Ba²⁺, Zn²⁺, Cu²⁺, Ni²⁺, Co²⁺, Cd²⁺, Ge²⁺, Sn²⁺, Pb²⁺, Hg²⁺, Al³⁺, Ga³⁺, In³⁺, Bi³⁺, Al³⁺, La³⁺, Ce³⁺, Eu³⁺, Th⁴⁺.

3. Method according to claim 1 or 2, **characterised by** the fact that said organic or inorganic salt comprises an organic cation selected from the group consisting of: 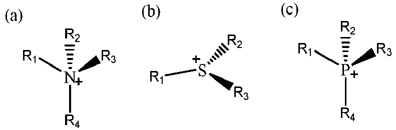 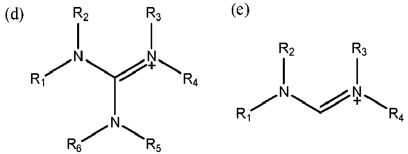 wherein
any of R₁, R₂, R₃, R₄, R₅, R₆ is independently selected from:
- H, provided that at least one of R₁, R₂, R₃, R₄, R₅, R₆ connected to a heteroatom is not H;
- a straight alkyl or branched alkyl containing 1-20 carbon atoms; or,
- straight alkenyl or branched alkenyl containing 2-20 carbon atoms and one or more double bonds;
- a straight alkynyl or branched alkynyl containing 2-20 carbon atoms and one or more triple bonds;
- a saturated, partial saturated or completely unsaturated cyclic alkyl containing 3-7 carbon atom.

4. Method according to claim 3, **characterised by** the fact that said substituents R₁, R₂, R₃, R₄, R₅, R₆ of the organic cations may be independently selected from -H, -CH₃,-C₂H₅, -C₃H₇, -CH(CH₃)₂, -C₄H₉, -C(CH₃)₃, -C₅H₁₁, -C₆H₁₃, -C₇H₁₅, -C₈H₁₇, -C₉H₁₉,-C₁₀H₂₁, -C₁₂H₂₅, -C₂₀H₄₁, -OCH₃, -OCH(CH₃)₂, -CH₂OCH₃, -C₂H₄OCH(CH₃)₂, -SCH₃,-SCH(CH₃)₂, -C₂H₄SC₂H₅, -C₂H₄SCH(CH₃)₂, -S(O)CH₃, -SO₂CH₃, -SO₂C₂H₅, -SO₂C₃H₇,-SO₂CH(CH₃)₂, -CH₂SO₂CH₃, -OSO₂CH₃, -OSO₂CF₃, -CH₂NHC₂H₅, -N(CH₃)C₃H₅,-N(CH₃)CF₃, -O-C₄H₈-O-C₄H₉, -S-C₂H₄-N(C₄H₉)₂, -OCF₃, -S(O)CF₃, -SO₂CF₃, -CF₃,-C₂F₅, -C₃F₇, -C₄F₉, -C(CF₃)₃, -CF₂SO₂CF₃, -C₂F₄N(C₂F₅)C₂F₅, -CF=CF₂, -C(CF₃)=CFCF₃, -CF₂CF=CFCF₃, -CF=CFN(CF₃)CF₃, -CFH₂, -CHF₂, -CH₂CF₃, -C₂F₂H₃, -C₃FH₆,-CH₂C₃F₇, -C(CFH₂)₃, -CHO, -C(O)OH, -CHC(O)OH, -CH₂C(O)C₂H₅, -CH₂C(O)OCH₃,-CH₂C(O)OC₂H₅, -C(O)CH₃, -C(O)OCH₃,

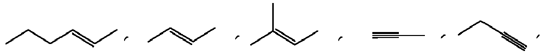

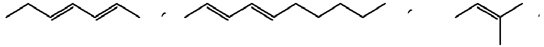

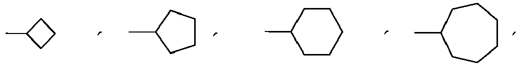

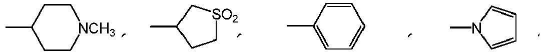

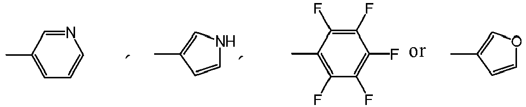

5. Method according to one of the preceding claims, **characterised by** the fact that said organic or inorganic salt comprises an anion selected from the group consisting of: F⁻, I⁻, Br⁻, Cl⁻, [N(CN)₂]⁻, [N(SO₂CF₃)₂]⁻, [PF₆]⁻, [BF₄]⁻, [NO₃]⁻, [C(CN)₃]⁻, [B(CN)₄]⁻, [CF₃COO]⁻, [ClO₄]⁻, [RSO₃]⁻, [(RSO₂)₂N]⁻, [(RSO₂)₃C]⁻, [(FSO₂)₃C]⁻, [RCH₂OSO₃]⁻, [RC(O)O]⁻, [CCl₃ C(O)O]⁻, [(CN)₂CR]⁻, [(R¹O(O)C)₂CR]⁻, [P(CₙF₂ₙ₊₁₋ₘHₘ)_{y}F_{6-y}]⁻, [P(C₆H₅)_{y}F_{6-y}]⁻, [R¹₂P(O)O]⁻, [R¹P(O)O₂]²⁻, [(R¹O)₂P(O)O]⁻, [(R¹O)P(O)O₂]²⁻, [(R¹O)(R¹)P(O)O]⁻, [R₂P(O)O]⁻, [RP(O)O₂]⁻, [BF₂R_{4-Z}]⁻, [BF₂(CN)_{4-Z}]⁻, [B(C₆F₅)₄]⁻, [B(OR¹)₄]⁻, [N(CF₃)₂]⁻, [AlCl₄]⁻ or [SiF₆]²⁻; wherein:
- n is an integer 1-20; m is 0, 1, 2, or 3; y is 0, 1, 2, 3 or 4; z is 0, 1, 2, or 3;
Rand R¹ are independently selected from:
- completely fluorinated alkyl containing 1-20 carbon atoms;
- completely fluorinated alkenyl containing 2-20 carbon atoms and one or more double bonds; or,
- completely fluorinated phenyl; or, saturated, partially unsaturated and or completely unsaturated cycloalkyl; or saturated, partially unsaturated and/ or completely unsaturated perfluoroalkyl.

6. Method according to one of the preceding claims,, **characterised by** the fact that said crown ether is selected from the group consisting of: 12-crown-[4], 15-crown-[5], 18-crown-[6], benzo-18-crown-[6], dibenzo-18-crown-[6], [2,4]-dibenzo-18-crown-[6], dibenzo-21-crown-[7], dibenzo-24-crown-[8], dibenzo-30-crown-[10], dicyclohexyl-18-crown-[6], N-phenylaza-15-crown-[5], 4',4"(5")-di-tert-butyldicyclohexano-18-crown-[6], 1,4,8,12-tetraazacyclopentadecane, 1,4,8,11-tetrathiacyclotetradecane, hexacyclen, 1,5,9,13-Tetrathiacyclohexadecane, 1-aza-18-crown-[6], diaza-18-crown-[6], hexaza-18-crown-[6], hexathia-18-crown-[6] and a mixture thereof.

7. Method according to one of the preceding claims, **characterised by the fact that** said so prepared perovskite film is formed by depositing perovskite precursors in a first solution in a first solvent onto said substrate and thereafter submitting the substrate covered by said first solution to a first annealing step.

8. Method according to one of the preceding claims, **characterised by** the fact that said organic or inorganic salt crown ether complex is applied in a second solution in a second solvent, wherein said second solvent is orthogonal to said first solvent versus said perovskite.

9. Method according to the preceding claims, **characterised by** the fact that after the application step of said organic or inorganic salt crown ether complex, said substrate with said perovskite film and with said applied organic or inorganic salt crown ether complex is submitted to a second annealing step.

10. Method according to one of the preceding claims, **characterised by** the fact that said substrate is part of an optoelectronic device selected from the group consisting of perovskite solar cells, perovskite light-emitting diodes, and perovskite photodetectors.

11. Method according to one of the preceding claims, **characterised by** the fact that said perovskite material comprises FAPbI₃.

12. Method according to one of the preceding claims, **characterised by** the fact that said organic or inorganic salt is an alkali metal halide salt.

13. Method according to the preceding claim, **characterised by** the fact that said alkali metal salt is CsI.

14. Method according to one of the preceding claims, **characterised by** the fact that said crown ether is dibenzo-21-crown-[7] and said alkali metal halide is CsI.

15. A perovskite solar cell, **characterised by** the fact that a perovskite layer of said perovskite solar cell contains an organic or inorganic salt presenting a graded concentration within said perovskite layer , the highest concentration of said organic or inorganic salt existing in vicinity of the perovskite layer surface distal to the substrate of said perovskite layer.

16. A perovskite solar cell according to the preceding claim, **characterised by the fact that** said perovskite material comprises FAPbI₃ and said organic or inorganic salt is CsI.

## Patentansprüche

1. Verfahren zur Modifizierung der Struktur eines auf einem Substrat hergestellten Perowskitfilms, **dadurch gekennzeichnet, dass** ein Komplex aus einem organischen oder anorganischen Salz und einem Kronenether bereitgestellt wird und dass der Komplex aus einem organischen oder anorganischen Salz und einem Kronenether auf eine freie Oberfläche des so hergestellten Perowskitfilms aufgebracht wird.

2. Verfahren nach Anspruch 1, **dadurch gekennzeichnet, dass** das organische oder anorganische Salz ein anorganisches Kation aus der Gruppe bestehend aus Tl⁺, Ag⁺, Li⁺, Na⁺, K⁺, Rb⁺, Cs⁺, Mg²⁺, Ca²⁺, Sr²⁺, Ba²⁺, Zn²⁺, Cu²⁺, Ni²⁺, Co²⁺, Cd²⁺, Ge²⁺, Sn²⁺, Pb²⁺, Hg²⁺, Al³⁺, Ga³⁺, In³⁺, Bi³⁺, Al³⁺, La³⁺, Ce³⁺, Eu³⁺, Th⁴⁺ umfasst.

3. Verfahren nach Anspruch 1 oder 2, **dadurch gekennzeichnet, dass** das organische oder anorganische Salz ein organisches Kation aus der Gruppe bestehend aus: 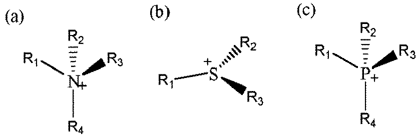 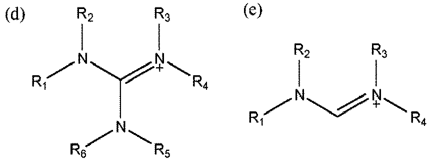 umfasst, wobei
R₁, R₂, R₃, R₄, R₅, R₆ jeweils unabhängig aus
- H, mit der Maßgabe, dass mindestens ein an ein Heteroatom gebundenes R₁, R₂, R₃, R₄, R₅, R₆ nicht H ist;
- einem geraden Alkyl oder verzweigten Alkyl mit 1-20 Kohlenstoffatomen oder
- einem geraden Alkenyl oder verzweigten Alkenyl mit 2-20 Kohlenstoffatomen und einer oder mehreren Doppelbindungen,
- einem geraden Alkinyl oder verzweigten Alkinyl mit 2-20 Kohlenstoffatomen und einer oder mehreren Dreifachbindungen,
- einem gesättigten, teilweise gesättigten oder vollständig ungesättigten cyclischen Alkyl mit 3-7 Kohlenstoffatomen
ausgewählt sind.

4. Verfahren nach Anspruch 3, **dadurch gekennzeichnet, dass** die Substituenten R₁, R₂, R₃, R₄, R₅, R₆ der organischen Kationen unabhängig aus -H, -CH₃, -C₂H₅, -C₃H₇, -CH(CH₃)₂, -C₄H₉, -C(CH₃)₃, -C₅H₁₁, -C₆H₁₃,-C₇H₁₅, -C₈H₁₇, -C₉H₁₉, -C₁₀H₂₁, -C₁₂H₂₅, -C₂₀H₄₁, -OCH₃,-OCH(CH₃)₂, -CH₂OCH₃, -C₂H₄OCH(CH₃)₂, -SCH₃, -SCH(CH₃)₂, -C₂H₄SC₂H₅, -C₂H₄SCH(CH₃)₂, -S(O)CH₃, -SO₂CH₃, -SO₂C₂H₅, -SO₂C₃H₇, -SO₂CH(CH₃)₂, -CH₂SO₂CH₃, -OSO₂CH₃, -OSO₂CF₃, -CH₂NHC₂H₅, -N(CH₃)C₃H₅, -N(CH₃)CF₃, -O-C₄H₈-O-C₄H₉,-S-C₂H₄-N(C₄H₉)₂, -OCF₃, -S(O)CF₃, -SO₂CF₃, -CF₃, -C₂F₅, -C₃F₇, -C₄F₉, -C(CF₃)₃, -CF₂SO₂CF₃, -C₂F₄N(C₂F₅)C₂F₅,-CF=CF₂, -C(CF₃)=CFCF₃, -CF₂CF=CFCF₃, -CF=CFN(CF₃)CF₃, -CFH₂, -CHF₂, -CH₂CF₃, -C₂F₂H₃, -C₃FH₆, -CH₂C₃F₇,-C(CFH₂)₃, -CHO, -C(O)OH, -CHC(O)OH, -CH₂C(O)C₂H₅,-CH₂C(O)OCH₃, -CH₂C (O)OC₂H₅, -C(O)CH₃, -C(O)OCH₃, 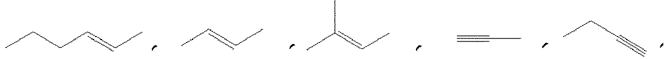 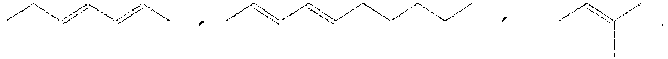 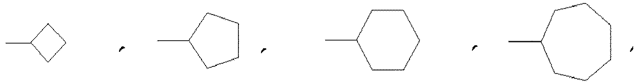 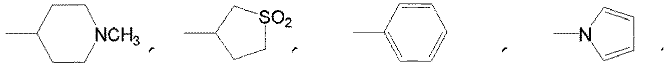 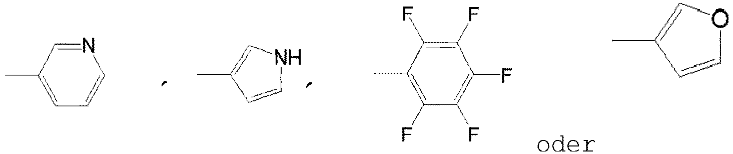 ausgewählt sein können.

5. Verfahren nach einem der vorhergehenden Ansprüche, **dadurch gekennzeichnet, dass** das organische oder anorganische Salz ein Anion aus der Gruppe bestehend aus F⁻, I⁻, Br⁻, Cl⁻, [N(CN)₂]⁻, [N(SO₂CF₃)₂]⁻, [PF₆]⁻, [BF₄]⁻, [NO₃]⁻, [C(CN)₃]⁻, [B(CN)₄]⁻, [CF₃COO]⁻, [ClO₄]⁻, [RSO₃]⁻, [(RSO₂)₂N]⁻, [(RSO₂)₃C]⁻, [(FSO₂)₃C]⁻, [RCH₂OSO₃]⁻, [RC(O)O]⁻, [CCl₃C(O)O]⁻, [(CN)₂CR]-, [(R¹O(O)C)₂CR]⁻, [P(CₙF₂ₙ₊₁₋ₘHₘ)_{y}F_{e-y}]⁻, [P(C₆H₅)_{y}F_{6-y}]⁻, [R¹₂P(O)O]⁻, [R¹P(O)O₂]²⁻, [(R²O)₂P(O)O]⁻, [(R¹O)P(O)₂]²⁻, [(R²O)(R¹)P(O)O]⁻, [R₂P(O)O]⁻, [RP(O)O₂]⁻, [BF₂R_{4-z}]⁻, [BF₂(CN)_{4-z}]⁻, [B(C₆F₅)₄]⁻, [B(OR¹)₄]⁻, [N(CF₃)₂]⁻, [AlCl₄]- oder [SiF₆]²⁻ umfasst;
wobei:
- n eine ganze Zahl von 1-20 ist; m 0, 1, 2 oder 3 ist; y 0, 1, 2, 3 oder 4 ist; z 0, 1, 2 oder 3 ist;
R und R¹ unabhängig aus
- vollständig fluoriertem Alkyl mit 1-20 Kohlenstoffatomen;
- vollständig fluoriertem Alkenyl mit 2-20 Kohlenstoffatomen und einer oder mehreren Doppelbindungen oder
- vollständig fluoriertem Phenyl oder gesättigtem, teilweise ungesättigtem oder vollständig ungesättigtem Cycloalkyl oder gesättigtem, teilweise ungesättigtem und/oder vollständig ungesättigtem Perfluoralkyl
ausgewählt sind.

6. Verfahren nach einem der vorhergehenden Ansprüche, **dadurch gekennzeichnet, dass** der Kronenether aus der Gruppe bestehend aus 12-Krone-[4], 15-Krone-[5], 18-Krone-[6], Benzo-18-krone-[6], Dibenzo-18-krone-[6], [2,4]-Dibenzo-18-krone-[6], Dibenzo-21-krone-[7], Dibenzo-24-krone-[8], Dibenzo-30-krone-[10], Dicyclohexyl-18-krone-[6], N-Phenylaza-15-krone-[5], 4',4", (5")-Di-tert-butyldicyclohexano-18-krone-[6], 1,4,8,12-Tetraazacyclopentadecan, 1,4,8,11-Tetrathiacyclotetradecan, Hexacyclen, 1,5,9,13-Tetrathiacyclohexadecan, 1-Aza-18-krone-[6], Diaza-18-krone-[6], Hexaza-18-krone-[6], Hexathia-18-krone-[6] und einer Mischung davon ausgewählt ist.

7. Verfahren nach einem der vorhergehenden Ansprüche, **dadurch gekennzeichnet, dass** der so hergestellte Perowskitfilm dadurch gebildet wird, dass man Perowskitvorstufen in einer ersten Lösung in einem ersten Lösungsmittel auf dem Substrat abscheidet und danach das mit der ersten Lösung bedeckte Substrat einem ersten Temperschritt unterwirft.

8. Verfahren nach einem der vorhergehenden Ansprüche, **dadurch gekennzeichnet, dass** der Komplex aus einem organischen oder anorganischen Salz und einem Kronenether in einer zweiten Lösung in einem zweiten Lösungsmittel aufgebracht wird, wobei das zweite Lösungsmittel zu dem ersten Lösungsmittel im Hinblick auf den Perowskit orthogonal ist.

9. Verfahren nach den vorhergehenden Ansprüchen, **dadurch gekennzeichnet, dass** man nach dem Schritt des Aufbringens des Komplexes aus einem organischen oder anorganischen Salz und einem Kronenether das Substrat mit dem Perowskitfilm und mit dem aufgebrachten Komplex aus einem organischen oder anorganischen Salz und einem Kronenether einem zweiten Temperschritt unterwirft.

10. Verfahren nach einem der vorhergehenden Ansprüche, **dadurch gekennzeichnet, dass** das Substrat Teil einer optoelektronischen Vorrichtung aus der Gruppe bestehend aus Perowskit-Solarzellen, Perowskit-Leuchtdioden und Perowskit-Photodetektoren ist.

11. Verfahren nach einem der vorhergehenden Ansprüche, **dadurch gekennzeichnet, dass** das Perowskitmaterial FAPbI₃ umfasst.

12. Verfahren nach einem der vorhergehenden Ansprüche, **dadurch gekennzeichnet, dass** das organische oder anorganische Salz ein Alkalimetallhalogenid-Salz ist..

13. Verfahren nach dem vorhergehenden Anspruch, **dadurch gekennzeichnet, dass** das Alkalimetallsalz CsI ist.

14. Verfahren nach einem der vorhergehenden Ansprüche, **dadurch gekennzeichnet, dass** der Kronenether Dibenzo-21-Krone-[7] ist und das Alkalimetallhalogenid CsI ist.

15. Perowskit-Solarzelle, **dadurch gekennzeichnet, dass** eine Perowskitschicht der Perowskit-Solarzelle ein organisches oder anorganisches Salz enthält, das eine abgestufte Konzentration innerhalb der Perowskitschicht aufweist, wobei die höchste Konzentration des organischen oder anorganischen Salzes in der Nähe der Oberfläche der Perowskitschicht distal zum Substrat der Perowskitschicht vorliegt.

16. Perowskit-Solarzelle nach dem vorhergehenden Anspruch, **dadurch gekennzeichnet, dass** das Perowskitmaterial FAPbI₃ umfasst und das organische oder anorganische Salz um CsI ist.

## Revendications

1. Procédé de modification de la structure d'un film de pérovskite préparé sur un substrat, **caractérisé par le fait qu'**un complexe de sel organique ou inorganique d'éther couronne est fourni et que ledit complexe de sel organique ou inorganique d'éther couronne est appliqué sur une surface libre du film de pérovskite ainsi préparé.

2. Procédé selon la revendication 1, **caractérisé par le fait que** ledit sel organique ou inorganique comprend un cation inorganique choisi dans le groupe constitué de : Tl⁺, Ag⁺, Li⁺, Na⁺, K⁺, Rb⁺, Cs⁺, Mg²⁺, Ca²⁺, Sr²⁺, Ba²⁺, Zn²⁺, Cu²⁺, Ni²⁺, Co²⁺, Cd²⁺, Ge²⁺, Sn²⁺, Pb²⁺, Hg²⁺, Al³⁺, Ga³⁺, In³⁺, Bi³⁺, Al³⁺, La³⁺, Ce³⁺, Eu³⁺, Th⁴⁺.

3. Procédé selon la revendication 1 ou 2, **caractérisé par le fait que** ledit sel organique ou inorganique comprend un cation organique choisi dans le groupe constitué de : 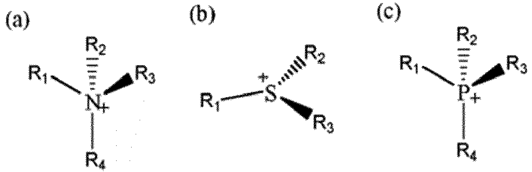 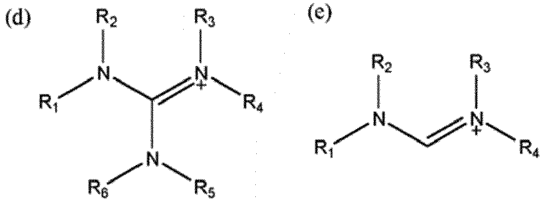 dans lequel
l'un quelconque de R₁, R₂, R₃, R₄, R₅, R₆ est indépendamment choisi parmi :
- H, à condition qu'au moins l'un de R₁, R₂, R₃, R₄, R₅, R₆ lié à un hétéroatome n'est pas H ;
- un alkyle linéaire ou un alkyle ramifié contenant 1 à 20 atomes de carbone ; ou,
- un alcényle linéaire ou un alcényle ramifié contenant 2 à 20 atomes de carbone et une ou plusieurs doubles liaisons ;
- un alcynyle linéaire ou un alcynyle ramifié contenant 2 à 20 atomes de carbone et une ou plusieurs triples liaisons ;
- un alkyle cyclique saturé, partiellement saturé ou complètement insaturé contenant 3 à 7 atomes de carbone.

4. Procédé selon la revendication 3, **caractérisé par le fait que** lesdits substituants R₁, R₂, R₃, R₄, R₅, R₆ des cations organiques peuvent être indépendamment choisis parmi -H, -CH₃, -C₂H₅, -C₃H₇, -CH(CH₃)₂, -C₄H₉, -C (CH₃)₃,-C₅H₁₁, -C₆H₁₃, -C₇H₁₅, -C₈H₁₇, -C₉H₁₉, -C₁₀H₂₁, -C₁₂H₂₅, -C₂₀H₄₁, -OCH₃, -OCH(CH₃)₂, -CH₂OCH₃, -C₂H₄OCH(CH₃)₂, -SCH₃,-SCH(CH₃)₂, -C₂H₄SC₂H₅, -C₂H₄SCH(CH₃)₂, -S(O)CH₃, -SO₂CH₃,-SO₂C₂H₅, -SO₂C₃H₇, -SO₂CH(CH₃)₂, -CH₂SO₂CH₃, -OSO₂CH₃,-OSO₂CF₃, -CH₂NHC₂H₅, -N(CH₃)C₃H₅, -N(CH₃)CF₃, -O-C₄H₈-O-C₄H₉, -S-C₂H₄-N(C₄H₉)₂, -OCF₃, -S(O)CF₃, -SO₂CF₃, -CF₃, -C₂F₅,-C₃F₇, -C₄F₉, -C(CF₃)₃, -CF₂SO₂CF₃, -C₂F₄N(C₂F₅)C₂F₅, -CF=CF₂, -C(CF₃)=CFCF₃, -CF₂CF=CFCF₃, -CF=CFN(CF₃)CF₃, -CFH₂, -CHF₂, -CH₂CF₃, -C₂F₂H₃, -C₃FH₆, -CH₂C₃F₇, -C(CFH₂)₃, -CHO, -C(O)OH, -CHC(O)OH, -CH₂C (O)C₂H₅, -CH₂C (O)OCH₃, -CH₂C (O)OC₂H₅,-C(O)CH₃, -C(O)OCH₃,

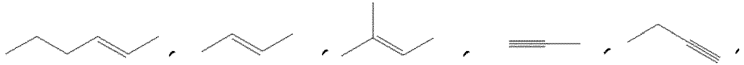

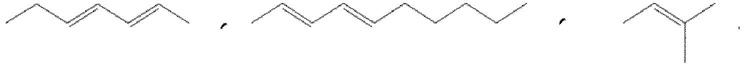

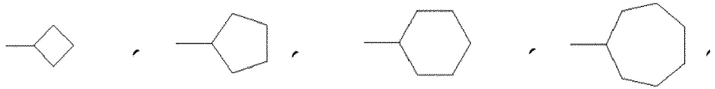

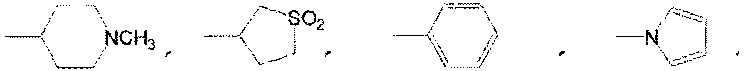

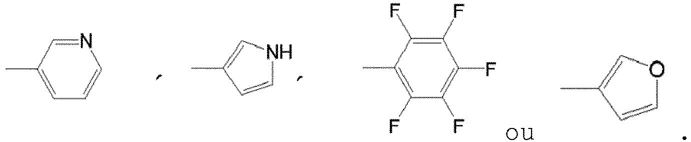

5. Procédé selon l'une des revendications précédentes, **caractérisé par le fait que** ledit sel organique ou inorganique comprend un anion choisi dans le groupe constitué de : F⁻, I⁻, Br⁻, Cl⁻, [N(CN)₂]⁻, [N(SO₂CF₃)₂]⁻, [PF₆]⁻, [BF₄]⁻, [NO₃]⁻, [C(CN)₃]⁻, [B(CN)₄]⁻, [CF₃COO]⁻, [ClO₄]⁻, [RSO₃]⁻, [(RSO₂)₂N]⁻, [(RSO₂)₃C]⁻, [(FSO₂)₃C]⁻, [RCH₂OSO₃]⁻, [RC(O)O]⁻, [CCl₃C(O)O]⁻, [(CN)₂CR]⁻, [(R¹O(O)C)₂CR]⁻, [P(CₙF₂ₙ₊₁₋ₘHₘ)_{y}F_{6-y}]⁻, [P(C₆H₅)_{y}F_{6-y}]⁻, [R¹₂P(O)O]⁻, [R¹P(O)O₂]²⁻, [(R²O)₂P(O)O]⁻, (R¹O)P(O)O₂]²⁻, [(R¹O)(R¹)P(O)O]⁻, [R₂P(O)O]⁻, [RP(O)O₂]⁻, [BF₂R₄-Z]⁻, [BF_{Z}(CN)_{4-Z}]⁻, [B(C₆F₅)₄]⁻, [B(OR¹)₄]⁻, [N(CF₃)₂]⁻, [AlCl₄]-ou [SiF₆]²⁻ ;
dans lequel :
- n est un entier de 1 à 20 ; m est 0, 1, 2 ou 3 ; y est 0, 1, 2, 3 ou 4 ; z est 0, 1, 2 ou 3 ;
R et R¹ sont indépendamment choisis parmi :
- alkyle complètement fluoré contenant 1 à 20 atomes de carbone ;
- alcényle complètement fluoré contenant 2 à 20 atomes de carbone et une ou plusieurs doubles liaisons ; ou,
- phényle complètement fluoré ; ou, cycloalkyle saturé, partiellement insaturé et/ou complètement insaturé ; ou perfluoroalkyle saturé, partiellement insaturé et/ou complètement insaturé.

6. Procédé selon l'une des revendications précédentes, **caractérisé par le fait que** ledit éther couronne est choisi dans le groupe constitué de : 12-couronne-[4], 15-couronne-[5], 18- couronne-[6], benzo-18-couronne-[6], dibenzo-18-couronne-[6], [2,4]-dibenzo-18-couronne-[6], dibenzo-21-couronne-[7], dibenzo-24-couronne-[8], dibenzo-30-couronne-[10], di cyclohexyl-18- couronne-[6], N-phénylaza-15-couronne-[5], 4',4"(5")-di-tert-butyldicyclohexano-18-couronne- [6], 1,4,8,12-tétraazacyclopentadécane, 1,4,8,11-tétrathiacyclotétradécane, hexacyclène, 1,5,9,13-tétrathiacyclohexadécane, 1-aza-18-couronne-[6], diaza-18-couronne-[6], hexaza-18- couronne-[6], hexathia-18-couronne-[6] et un mélange de ceux-ci.

7. Procédé selon l'une des revendications précédentes, **caractérisé par le fait que** ledit film de pérovskite préparé ainsi est formé par dépôt de précurseurs de pérovskite dans une première solution dans un premier solvant sur ledit substrat et ensuite, soumission du substrat recouvert par ladite première solution à une première étape de recuit.

8. Procédé selon l'une des revendications précédentes, **caractérisé par le fait que** ledit complexe de sel organique ou inorganique d'éther couronne est appliqué dans une deuxième solution dans un deuxième solvant, dans lequel ledit deuxième solvant est orthogonal audit premier solvant par rapport à ladite pérovskite.

9. Procédé selon les revendications précédentes, **caractérisé par le fait que**, après l'étape d'application dudit complexe de sel organique ou inorganique d'éther couronne, ledit substrat avec ledit film de pérovskite et avec ledit complexe de sel organique ou inorganique d'éther couronne appliqué est soumis à une deuxième étape de recuit.

10. Procédé selon l'une des revendications précédentes, **caractérisé par le fait que** ledit substrat fait partie d'un dispositif opto-électronique choisi dans le groupe constitué de cellules solaires à pérovskite, diodes électroluminescentes à pérovskite et de photodétecteurs à pérovskite.

11. Procédé selon l'une des revendications précédentes, **caractérisé par le fait que** ledit matériau de pérovskite comprend FAPbI₃.

12. Procédé selon l'une des revendications précédentes, **caractérisé par le fait que** ledit sel organique ou inorganique est un sel d'halogénure de métal alcalin.

13. Procédé selon la revendication précédente, **caractérisé par le fait que** ledit sel de métal alcalin est CsI.

14. Procédé selon l'une des revendications précédentes, **caractérisé par le fait que** ledit éther couronne est dibenzo-21-couronne-[7] et ledit halogénure de métal alcalin est CsI.

15. Cellule solaire à pérovskite, **caractérisé par le fait qu'**une couche de pérovskite de ladite cellule solaire à pérovskite contient un sel organique ou inorganique présentant un gradient de concentration dans ladite couche de pérovskite, la concentration la plus élevée dudit sel organique ou inorganique existant à proximité de la surface de la couche de pérovskite distale par rapport au substrat de ladite couche de pérovskite.

16. Cellule solaire à pérovskite selon la revendication précédente, **caractérisée par le fait que** ledit matériau de pérovskite comprend FAPbI₃ et ledit sel organique ou inorganique est CsI.
